# EUROPEAN PATENT APPLICATION

(11) **EP 4 687 408 A1**
(43) Date of publication of application: **04.02.2026**
(21) Application number: 25191137.6
(22) Date of filing: 22.07.2025
(51) Int. Cl.: H10P 72/76, H10P 72/00

(54) **WAFER TRANSFER DEVICE**

(30) Priority: 02.08.2024 TW 113128907
(71) Applicant: Machsync Co., Ltd., Taichung City, 428 (TW)
(72) Inventor: CHEN, JUI-TENG, 404 Taichung City (TW)
(74) Representative: Cabinet Chaillot

(57) **Abstract**

A wafer transfer device for carrying a wafer includes a body and three strain sensing components. The body has a handle portion and a carrying portion connected to each other. The carrying portion is used to carry the wafer. The carrying portion has two forks, and the two forks are arranged at intervals from each other. The body has a first surface and a second surface opposite to each other; the three strain sensing components are respectively arranged at the two forks and the handle portion, and each of the strain sensing components includes two strain sensing elements. The two strain sensing elements of each strain sensing component are symmetrically arranged on the first surface and the second surface.

## Description

### BACKGROUND OF THE INVENTION

### Technical Field

The present invention relates generally to a wafer transfer device, and more particularly to a wafer transfer device having a strain sensing component.

### Description of Related Art

It is known that in the field of semiconductor industry, a wafer transfer device such as a robotic arm is used to perform wafer transfer operations to achieve more precise transfer movements. However, although the wafer transfer device is controlled by a computer, when the wafer transfer device is subjected to external force collision or other interference, the wafer transfer device will still produce abnormal vibrations or cause the position of the wafer to shift, thereby affecting the accuracy of wafer transfer.

As mentioned above, in order to improve the accuracy of wafer handling, a sensor is generally installed on the wafer transfer device to instantly sense the movement or vibration of the wafer transfer device. However, the location of the sensor will greatly affect the accuracy of the sensor's sensing. Therefore, how to provide a wafer transfer device that can improve the accuracy of the sensor's sensing is an urgent problem to be solved.

### BRIEF SUMMARY OF THE INVENTION

In view of the above, the primary objective of the present invention is to provide a wafer transfer device that can greatly improve the accuracy of sensor sensing.

The present invention provides a wafer transfer device, wherein the wafer transfer device is used to carry a wafer, which includes: a body, wherein the body has a handle portion and a carrying portion connected to each other, the carrying portion is used to carry the wafer, the carrying portion has two forks, the two forks are spaced apart from each other, and the body has a first surface and a second surface opposite to each other; and three strain sensing components, wherein the three strain sensing components are respectively arranged at the two forks and the handle portion, each of the strain sensing components comprises two strain sensing elements, and the two strain sensing elements of each strain sensing component are respectively symmetrically arranged at the first surface and the second surface.

In an embodiment, the two strain sensing components disposed on the two forks are symmetrically disposed with respect to each other.

In an embodiment, the handle portion has a first section and a second section connected to each other, one end of the first section is connected to the carrying portion, and the other end of the first section is connected to the second section, wherein a width of the first section gradually decreases from a connection with the carrying portion to a connection with the second section, and the strain sensing component disposed on the handle portion is located at the connection between the first section and the second section.

In an embodiment, a width of the second section is less than or equal to a width of the connection between the first section and the second section.

In an embodiment, the body has three mounting parts corresponding to the mounting positions of the three strain sensing components, each of the mounting parts includes two grooves, the two grooves of each mounting part are symmetrically arranged on the first surface and the second surface, and the two grooves of each mounting part are respectively formed by being concave from the surface of the first surface and the second surface, and each of the grooves correspondingly accommodates one of the strain sensing elements.

In an embodiment, the wafer transfer device further includes six packaging materials, wherein the six packaging materials are correspondingly disposed in the six grooves and cover the six strain sensing elements.

In an embodiment, the wafer transfer device further includes a circuit board component electrically connected to the three strain sensing components respectively, and the circuit board component receives a sensing signal output by each of the strain sensing components respectively.

In an embodiment, the wafer transfer device further includes a plurality of electrical conductive members, the six strain sensing elements are electrically connected to the circuit board component through the plurality of electrical conductive members.

In an embodiment, the wafer transfer device further includes a plurality of electrically conductive member slots, the plurality of electrically conductive member slots are arranged on the first surface and the second surface, and the plurality of electrically conductive member slots are respectively formed by being concavely formed from the surfaces of the first surface and the second surface, and the plurality of electrical conductive members are correspondingly accommodated in the plurality of electrically conductive member slots.

In an embodiment, each of the strain sensing elements comprises two strain sensing structures, and the strain sensing structures of the two strain sensing elements symmetrically arranged on the first surface and the second surface are electrically connected to form a Wheatstone bridge, wherein the Wheatstone bridge has a first arm and a second arm, wherein the two strain sensing structures of one of the strain sensing elements are respectively located at an upper arm of the first arm and a lower arm of the second arm; and the two strain sensing structures of the other strain sensing element are respectively located at a lower arm of the first arm and an upper arm of the second arm.

The effect of the present invention is that the three strain sensing components are respectively arranged at the two forks and the handle portion, so that the three strain sensing components can not only sense the strain of the body at the two forks, but also sense the strain of the body at the handle portion. The three strain sensing components can accurately sense the strain of the body and output a sensing signal for user reference.

### BRIEF DESCRIPTION OF THE SEVERAL VIEWS OF THE DRAWINGS

The present invention will be best understood by referring to the following detailed description of some illustrative embodiments in conjunction with the accompanying drawings, in which
FIG. 1 is a perspective view of a wafer transfer device according to an embodiment of the present invention;
FIG. 2 is a top view of the wafer transfer device according to the embodiment of the present invention;
FIG. 3 is a stress distribution diagram of the body;
FIG. 4 is a cross-sectional view taken along the 4-4 direction of FIG2;
FIG. 5 is a schematic diagram of the strain sensing component and the circuit board of the embodiment of the present invention;
FIG. 6 is a schematic diagram of two strain sensing elements of the strain sensing component of the embodiment of the present invention;
FIG. 7 is a circuit diagram of the strain sensing component of the embodiment of the present invention;
FIG. 8 is a top view of the wafer transfer device of the embodiment of the present invention.

### DETAILED DESCRIPTION OF THE INVENTION

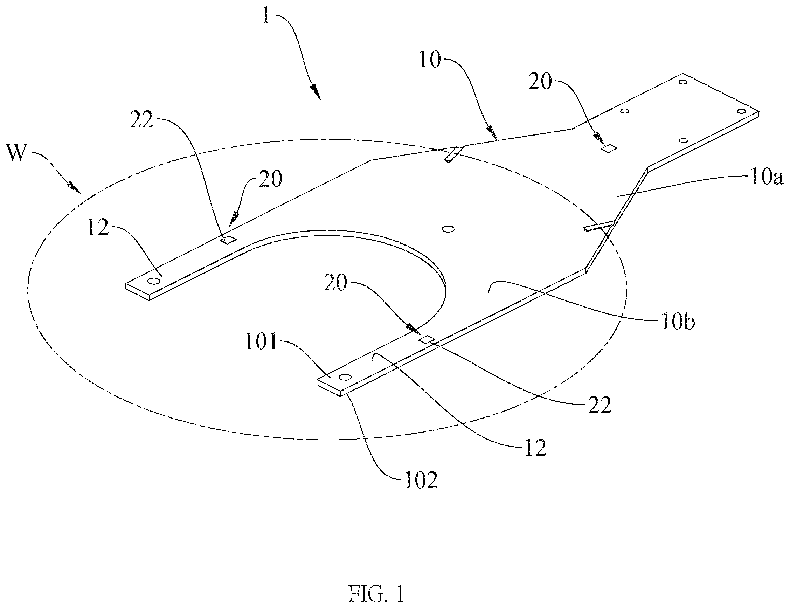

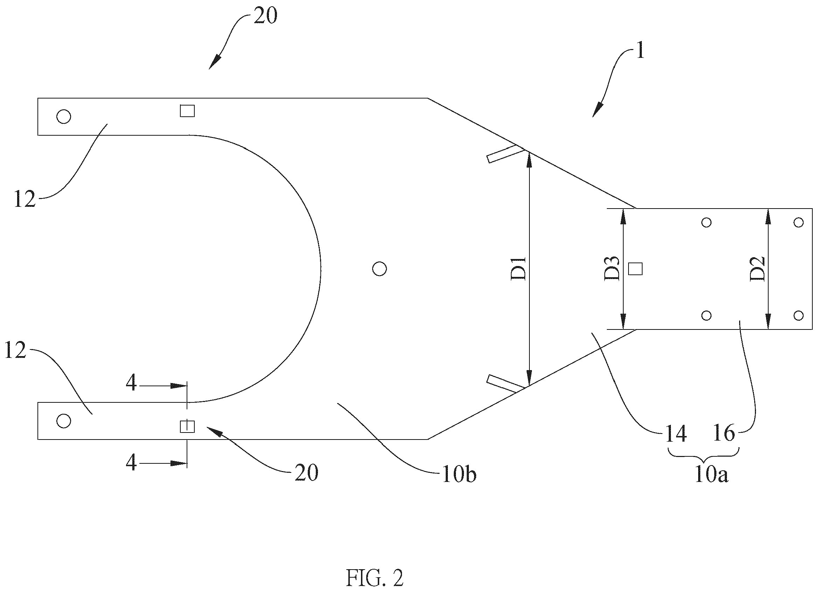

A wafer transfer device 1 according to an embodiment of the present invention is illustrated in FIG. 1 and FIG. 2.

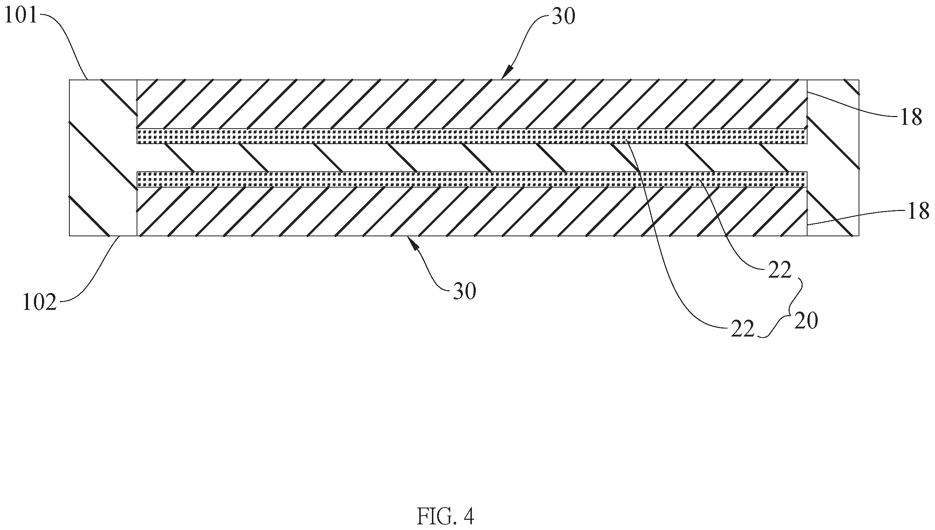

The wafer transfer device 1 is used to carry a wafer W. The wafer transfer device 1 includes a body 10and three strain sensing components 20. The body 10 has a handle portion 10a and a carrying portion 10b, the handle portion 10a and the carrying portion 10b are connected to each other, and the body 10 has a first surface 101 and a second surface 102 opposite to each other (please refer to FIG. 4). The handle portion 10a can be connected to a robot arm. The carrying portion 10b is used to carry the wafer W at the first surface 101. The carrying portion 10b has two forks 12. The two forks 12 are spaced apart and symmetrically arranged. The three strain sensing components 20 are respectively arranged at the two forks 12 and the handle portion 10a, and each of the strain sensing components 20 includes two strain sensing elements 22. The two strain sensing elements 22 of each of the strain sensing components 20 are respectively symmetrically arranged at the first surface 101 and the second surface 102 (please refer to FIG. 4). The three strain sensing components 20 can not only sense the strain of the body 10at the two forks 12, but also sense the strain of the body 10at the handle 10a. Therefore, the three strain sensing components 20 can accurately sense the strain of the body 10and output a sensing signal for the user's reference.

As shown in FIG. 2 , the two strain sensing components 20 disposed on the two forks 12 are symmetrically disposed with each other; the handle portion 10a has a first section 14 and a second section 16 connected to each other, one end of the first section 14 is connected to the carrying portion 10b, and the other end of the first section 14 is connected to the second section 16, wherein the width D1 of the first section 14 gradually decreases from the connection with the carrying portion 10b to the connection with the second section 16, and the width D2 of the second section 16 is less than or equal to the width D3 of the connection between the first section 14 and the second section 16, and the strain sensing component 20 disposed on the handle portion 10a is located at the connection between the first section 14 and the second section 16. Thereby, the strain sensing component 20 disposed on the handle 10a can be located in the stress concentration area of the handle 10a, so that the accuracy of the strain sensing component 20 disposed on the handle 10a in sensing the wafer transfer device 1 can be improved.

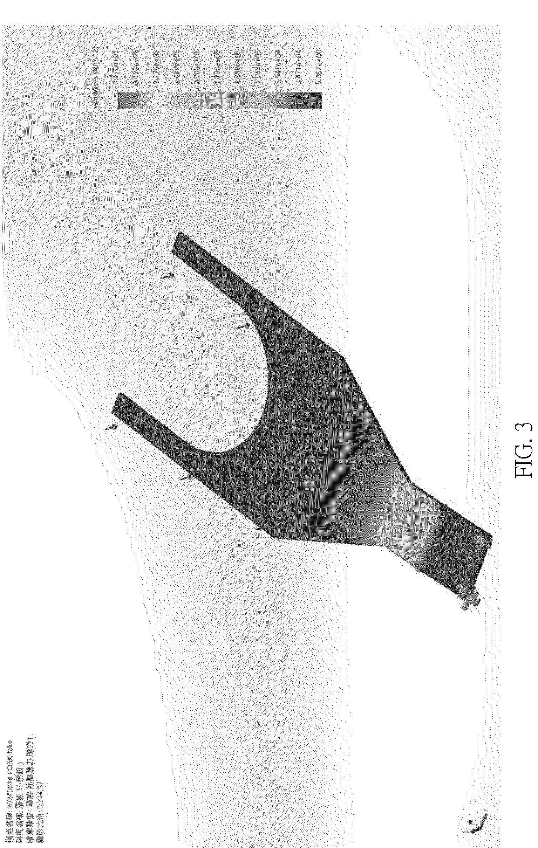

As shown in FIG. 3, which is a stress distribution diagram of the body 10. FIG. 3 is the result of a finite element analysis of the material and average stress state of the body 10. As can be seen from FIG. 3, the connection between the first section 14 and the second section 16 on the handle portion 10a is a stress concentration area. In other words, the strain sensing component 20 disposed at the connection between the first section 14 and the second section 16 on the handle portion 10a can be located in the stress concentration area of the handle 10a, thereby improving the accuracy of sensing the strain of the wafer transfer device 1.

The body 10 has three mounting portions corresponding to the three mounting positions of the three strain sensing components 20, and as shown in FIG. 4 , each mounting portion includes two grooves 18, and the two grooves 18 of each mounting portion are symmetrically disposed on the first surface 101 and the second surface 102, respectively, and the two grooves 18 of each mounting portion are formed by being concavely formed from the surface of the first surface 101 and the second surface 102, respectively, and each of the grooves 18 accommodates one strain sensing element 22. A total of six grooves 18 are disposed on the first surface 101 and the second surface 102 of the two tooth forks 12 and the first surface 101 and the second surface 102 of the handle 10a; as shown in FIG4 , in this embodiment, the wafer transfer device 1 further includes six packaging materials 30, which are correspondingly arranged in the six grooves 18 and cover the six strain sensing elements 22, wherein the packaging materials 30 can be packaging materials made of materials such as epoxy resin, but are not limited thereto. Thus, each of the strain sensing elements 22 can be covered by each of the packaging materials 30 and firmly arranged in each of the grooves 18 and isolated from the external space.

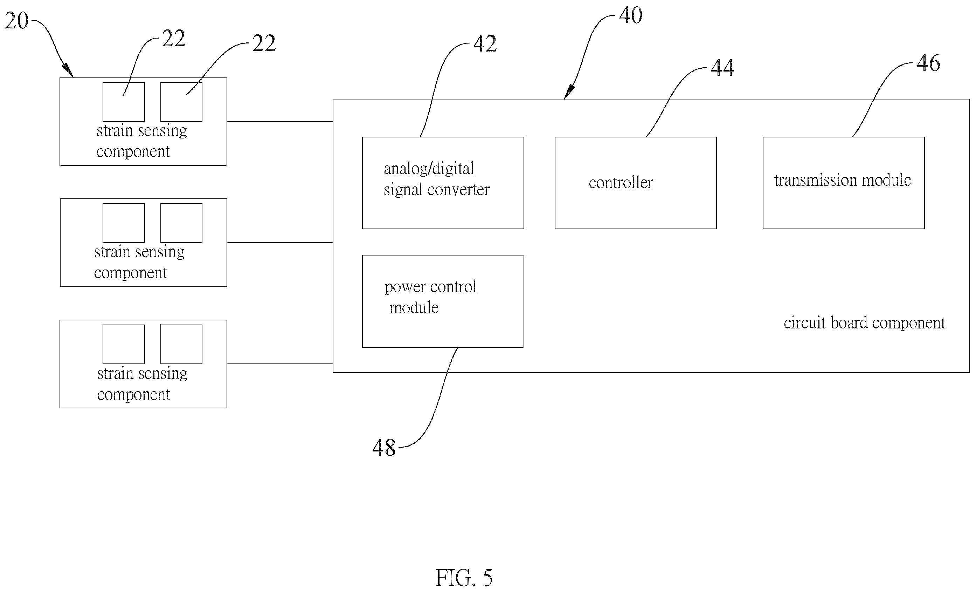

As shown in FIG. 5, in this embodiment, the wafer transfer device 1 further includes a circuit board component 40 electrically connected to the three strain sensing components 20, and the circuit board component 40 receives a sensing signal VS1 output by each of the strain sensing components 20. Further, the circuit board component 40 is provided with an analog/digital signal converter 42, a controller 44, a transmission module 46 and a power control module 48. The controller 44 may be, for example, a microcontroller, and the transmission module 46 may be, for example, a wired transmission module or a wireless transmission module. In this embodiment, a wireless transmission module is used as an example. Each of the strain sensing components 20 may receive an input voltage Vi from the power control module 48, and convert the input voltage Vi into the sensing signal VS1. The two strain sensing elements 22 of each strain sensing component 20 are electrically connected to the analog/digital signal converter, wherein the controller 44 is electrically connected to the analog/digital signal converter 42 and the transmission module 46. The controller 44 obtains the sensing signal VS1 of each strain sensing component 20 through the analog/digital signal converter 42, and transmits the sensing signal VS1 of each strain sensing component 20 to an external electronic device through the transmission module 46. Thus, an operator can receive the sensing signal VS1 of each strain sensing component 20 in real time through an external electronic device and effectively monitor and analyze the sensing signal VS1.

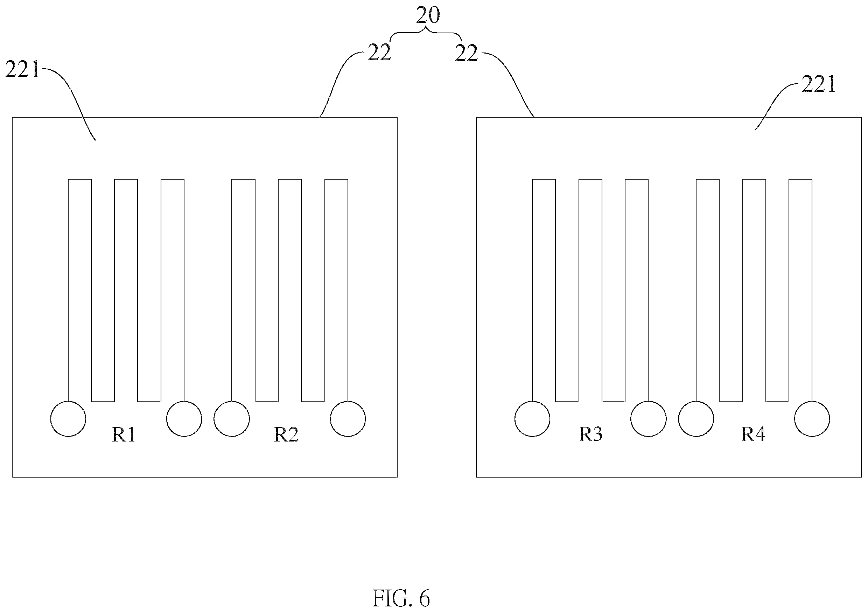

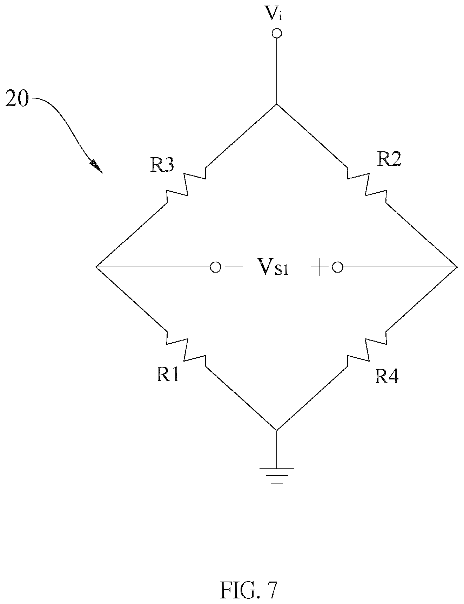

As described above, each of the strain sensing components 20 includes two strain sensing elements 22. To be further described, each of the strain sensing elements 22 includes a flexible substrate 221 and two strain sensing structures, the two strain sensing structures are disposed on the flexible substrate. As shown in FIG. 6, the flexible substrate 221 of one of the strain sensing elements 22 of each of the strain sensing components 20 is provided with two strain sensing structures R1 and R2, and the flexible substrate 221 of the other strain sensing element 22 is provided with two strain sensing structures R3 and R4. Each of the strain sensing structures R1 to R4 has a resistance value, and the two strain sensing elements 22 are electrically connected to form a Wheatstone bridge as shown in FIG. 7. The Wheatstone bridge has a first arm and a second arm, wherein the two strain sensing structures R3 and R4 of one strain sensing element 22 are respectively located at an upper arm of the first arm and a lower arm of the second arm; the two strain sensing structures R1 and R2 of the other strain sensing element 22 are respectively located at a lower arm of the first arm and an upper arm of the second arm.

When the body 10 is subjected to stress, the resistance value of each of the strain sensing structures R1~R4 of each of the strain sensing components 20 changes accordingly. Specifically, when one side of the body 10 is compressed and the other side is relatively stretched, the resistance value of the strain sensing element 22 corresponding to the compressed side is smaller than the resistance value of the other strain sensing element 22, so as to generate the corresponding sensing signal VS1. When the stress applied to the body 10 is greater, the absolute value of the sensing signal VS1 is greater. Since the resistance values on the two strain sensing elements 22 change relatively (i.e., the resistance value of the two strain sensing structures R1, R2 or R3, R4 on one strain sensing element increases, and the resistance value of the two strain sensing structures R3, R4 or R1, R2 on the other strain sensing element decreases), the sensing signal VS1 can be increased by combining with the Wheatstone bridge structure, that is, the sensitivity of the sensing signal VS1 is effectively increased.

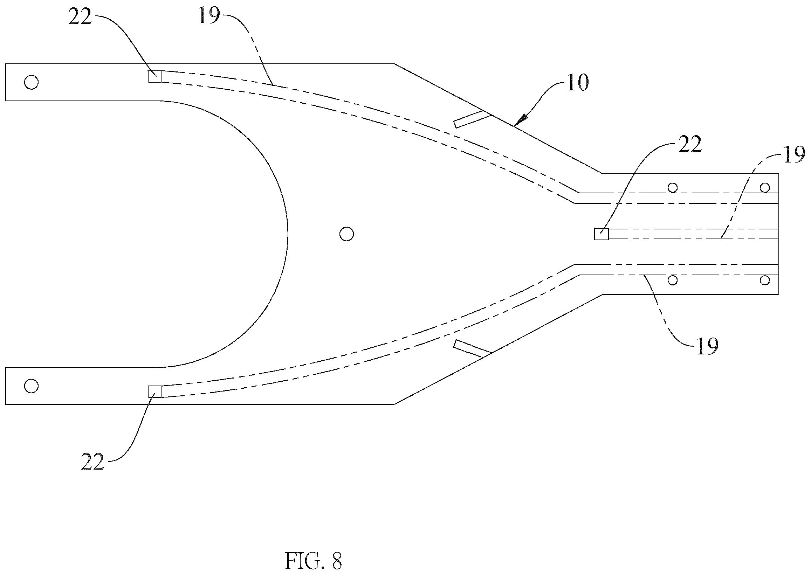

Further, the wafer transfer device 1 includes a plurality of electrically conductive members, and the strain sensing elements are electrically connected to the circuit board component through the electrically conductive members. The electrically conductive members may be, for example, wires or flexible circuit boards. In addition, as shown in FIG. 8 , the body 10 further includes a plurality of electrically conductive member slots 19, and the electrically conductive member slots 19 are disposed on the first surface 101 and the second surface 102, and the electrically conductive member slots 19 are respectively formed by being concave from the surfaces of the first surface 101 and the second surface 102, and the electrically conductive members 50 are correspondingly accommodated in the electrically conductive member slots 19. Preferably, the packaging materials may also be correspondingly disposed in the electrically conductive member grooves 19 to cover the electrically conductive members.

In summary, the effect of the present invention is that, through the design of respectively arranging the three strain sensing components 20 at the two forks 12 and the handle portion 10a, the three strain sensing components 20 can not only sense the strain of the main body 10 at the two forks 12, but also sense the strain of the body 10 at the handle portion 10a. Thus, the three strain sensing components 20 can accurately sense the strain of the body 10 and output a sensing signal for the user's reference.

It must be pointed out that the embodiments described above are only some preferred embodiments of the present invention. All equivalent structures and methods which employ the concepts disclosed in this specification and the appended claims should fall within the scope of the present invention.

## Claims

1. A wafer transfer device, wherein the wafer transfer device is used to carry a wafer, comprising:
a body, wherein the body has a handle portion and a carrying portion connected to each other, the carrying portion is used to carry the wafer, the carrying portion has two forks, the two forks are spaced apart from each other, and the body has a first surface and a second surface opposite to each other; and
three strain sensing components, wherein the three strain sensing components are respectively arranged at the two forks and the handle portion, each of the strain sensing components comprises two strain sensing elements, and the two strain sensing elements of each strain sensing component are respectively symmetrically arranged at the first surface and the second surface.

2. The wafer transfer device as claimed in claim 1, wherein the two strain sensing components disposed on the two forks are symmetrically disposed with respect to each other.

3. The wafer transfer device as claimed in claim 1, wherein the handle portion has a first section and a second section connected to each other, one end of the first section is connected to the carrying portion, and the other end of the first section is connected to the second section, wherein a width of the first section gradually decreases from a connection with the carrying portion to a connection with the second section, and the strain sensing component disposed on the handle portion is located at the connection between the first section and the second section.

4. The wafer transfer device as claimed in claim 3, wherein a width of the second section is less than or equal to a width of the connection between the first section and the second section.

5. The wafer transfer device as claimed in claim 1, wherein the body has three mounting parts corresponding to the mounting positions of the three strain sensing components, each of the mounting parts includes two grooves, the two grooves of each mounting part are symmetrically arranged on the first surface and the second surface, and the two grooves of each mounting part are respectively formed by being concave from the surface of the first surface and the second surface, and each of the grooves correspondingly accommodates one of the strain sensing elements.

6. The wafer transfer device as claimed in claim 5, further includes six packaging materials, wherein the six packaging materials are correspondingly disposed in the six grooves and cover the six strain sensing elements.

7. The wafer transfer device as claimed in claim 2, wherein the body has three mounting parts corresponding to the mounting positions of the three strain sensing components, each of the mounting parts includes two grooves, the two grooves of each mounting part are symmetrically arranged on the first surface and the second surface, and the two grooves of each mounting part are respectively formed by being concave from the surface of the first surface and the second surface, and each of the grooves correspondingly accommodates one of the strain sensing elements.

8. The wafer transfer device as claimed in claim 7, further includes six packaging materials, wherein the six packaging materials are correspondingly disposed in the six grooves and cover the six strain sensing elements.

9. The wafer transfer device as claimed in claim 3, wherein the body has three mounting parts corresponding to the mounting positions of the three strain sensing components, each of the mounting parts includes two grooves, the two grooves of each mounting part are symmetrically arranged on the first surface and the second surface, and the two grooves of each mounting part are respectively formed by being concave from the surface of the first surface and the second surface, and each of the grooves correspondingly accommodates one of the strain sensing elements.

10. The wafer transfer device as claimed in claim 9, further includes six packaging materials, wherein the six packaging materials are correspondingly disposed in the six grooves and cover the six strain sensing elements.

11. The wafer transfer device as claimed in claim 4, wherein the body has three mounting parts corresponding to the mounting positions of the three strain sensing components, each of the mounting parts includes two grooves, the two grooves of each mounting part are symmetrically arranged on the first surface and the second surface, and the two grooves of each mounting part are respectively formed by being concave from the surface of the first surface and the second surface, and each of the grooves correspondingly accommodates one of the strain sensing elements.

12. The wafer transfer device as claimed in claim 11, further includes six packaging materials, wherein the six packaging materials are correspondingly disposed in the six grooves and cover the six strain sensing elements.

13. The wafer transfer device as claimed in claim 1, further includes a circuit board component electrically connected to the three strain sensing components respectively, and the circuit board component receives a sensing signal output by each of the strain sensing components respectively.

14. The wafer transfer device as claimed in claim 13, further includes a plurality of electrical conductive members, the six strain sensing elements are electrically connected to the circuit board component through the plurality of electrical conductive members.

15. The wafer transfer device as claimed in claim 14, further includes a plurality of electrically conductive member slots, the plurality of electrically conductive member slots are arranged on the first surface and the second surface, and the plurality of electrically conductive member slots are respectively formed by being concavely formed from the surfaces of the first surface and the second surface, and the plurality of electrical conductive members are correspondingly accommodated in the plurality of electrically conductive member slots.

16. The wafer transfer device as claimed in claim 1, wherein each of the strain sensing elements comprises two strain sensing structures, and the strain sensing structures of the two strain sensing elements symmetrically arranged on the first surface and the second surface are electrically connected to form a Wheatstone bridge, wherein the Wheatstone bridge has a first arm and a second arm, wherein the two strain sensing structures of one of the strain sensing elements are respectively located at an upper arm of the first arm and a lower arm of the second arm; and the two strain sensing structures of the other strain sensing element are respectively located at a lower arm of the first arm and an upper arm of the second arm.
